# EUROPEAN PATENT APPLICATION

(11) **EP 4 480 995 A1**
(43) Date of publication of application: **25.12.2024**
(21) Application number: 23752792.4
(22) Date of filing: 03.02.2023
(51) Int. Cl.: C08J 5/18, B29D 7/01, B32B 9/00, B32B 15/085, B32B 27/18, B32B 27/32, B65D 65/40, C08K 3/08, C08K 3/22, C08K 3/36, C08L 23/12

(54) **POLYPROPYLENE FILM, LAMINATE, PACKAGING MATERIAL, PACKAGED BODY, AND METHOD FOR MANUFACTURING SAME**

(30) Priority: 14.02.2022 JP 2022020212
(71) Applicant: Toray Industries, Inc., Tokyo 103-8666 (JP)
(72) Inventor: IMANISHI, Yasuyuki, Otsu-shi, Shiga 520-8558 (JP); OHKURA, Masatoshi, Otsu-shi, Shiga 520-8558 (JP); AONO, Haruki, Otsu-shi, Shiga 520-8558 (JP)
(74) Representative: Mewburn Ellis LLP
(86) International application number: PCT/JP2023/003567
(87) International publication number: WO 2023/153327

(57) **Abstract**

This polypropylene film includes particles. Regarding the polypropylene film, when the direction in which the shrinkage ratio is largest at 140°C in a temperature increase process for a thermomechanical analysis is defined as X1 direction, and when the temperature at which a 1% shrinkage occurs in the X1 direction is defined as X1Ts, XlTs is 100-160°C. The particles are metal particles and/or inorganic compound particles. Provided is a polypropylene film that has, even while using a recycled deposited film, excellent thermal dimensional stability, and high oxygen barrier properties and water vapor barrier properties.

## Description

### TECHNICAL FIELD

The present invention particularly relates to a polypropylene film, a laminate, a packaging material, and a packaged body suitably used in packaging applications, and a method for manufacturing the same.

### BACKGROUND ART

Polypropylene films are excellent in transparency, mechanical characteristics, electrical characteristics, and the like, and have been thus used in various applications such as packaging applications, tape applications, and electrical insulation applications including cable wrapping and capacitors. Among them, in packaging applications, a laminate in which a thin film of a metal such as aluminum (hereinafter may be referred to as "Al") or an inorganic compound such as aluminum oxide (hereinafter may be referred to as "AlOx" or "alumina") or silicon oxide is vapor-deposited on a polypropylene film is widely used.

Laminates for packaging applications are required to have high water vapor barrier properties and oxygen barrier properties, and in the case of laminating a thin film of an inorganic compound, transparency is also required from the viewpoint of obtaining visibility of contents. Furthermore, since a polypropylene film to be a base material for vapor deposition is required to have appropriate conveyability at the time of vapor deposition processing or bag-forming processing, an antiblocking agent or particles may be added to the surface layer to form irregularities on the surface to impart lubricity.

Specifically, for example, Patent Document 1 proposes a polypropylene film in which an increase in haze is suppressed by controlling the formation of spherulites by containing a small amount of alumina having an average particle diameter of 0.01 to 10 um and utilizing the alumina as a nucleating agent, and both processability and transparency are achieved. Similarly, Patent Document 2 proposes a polypropylene film in which barrier properties, shrinkability, tear strength, and transparency are improved by adding a silicate, preferably a nano-sized inorganic filler selected from nano-hydrotalcite and phyllosilicate. Furthermore, Patent Document 3 proposes a polypropylene film in which the smoothness, peelability, and transparency of both surfaces of the film are improved by including silica particles only in the surface layer of the polypropylene film having a laminated configuration.

It is also important from the viewpoint of environmental consideration to recycle the packaging plastic to produce a packaging material at low cost. For example, Patent Document 4 proposes a method in which a laminated film having an aluminum deposited layer and a plastic film not having an aluminum deposited layer are melt-kneaded to be recycled and pelletized. In this method, the presence of aluminum particles at a nanometer level derived from the aluminum deposited layer in the kneaded product suppresses the surging phenomenon, so that recycled pellets can be stably produced.

### PRIOR ART DOCUMENT

### PATENT DOCUMENTS

Patent Document 1: Japanese Patent Laid-open Publication No. 09-111054
Patent Document 2: National Publication of International Patent Application No. 2008-542511
Patent Document 3: Japanese Patent Laid-open Publication No. 2015-178594
Patent Document 4: Japanese Patent Laid-open Publication No. 2013-35272

### SUMMARY OF THE INVENTION

### PROBLEMS TO BE SOLVED BY THE INVENTION

However, in the polypropylene films of Patent Documents 1, 2 and 3, stretching and heat treatment conditions during film formation are insufficient to obtain thermal dimensional stability. Therefore, there is a problem that heat resistance under a high-temperature environment is insufficient, the polypropylene film is easily deformed by heat during vapor deposition, defects and cracks are formed in the vapor deposited film, and oxygen barrier and water vapor barrier properties are easily impaired. In addition, the method in Patent Document 4 is a method capable of stably performing recycle pelletization of an aluminum deposited film, but this method is intended to be used for a molding material, and there is a problem that it is insufficient to be used for production of a film for packaging materials for which barrier properties are required. More specifically, the polypropylene films and recycling technologies in Patent Documents 1 to 4 have a problem that it is difficult to apply the films to applications that require processing and using the films under high-temperature environments, and at the same time, require high barrier properties.

Therefore, an object of the present invention is to provide a polypropylene film having excellent thermal dimensional stability, and high oxygen barrier properties and water vapor barrier properties even while using a recycled deposited film.

### SOLUTIONS TO THE PROBLEMS

The present inventors have conducted intensive studies in order to solve the above problems and have invented a first polypropylene film of the present invention and a second polypropylene film of the present invention below. That is, the first polypropylene film of the present invention is a polypropylene film containing a particle, in which a temperature X1Ts is 100°C or more and 160°C or less where a direction in which a shrinkage ratio is largest at 140°C in a temperature increase process of thermomechanical analysis (TMA) is defined as an X1 direction, and a temperature at which a 1% shrinkage occurs in the X1 direction is defined as the temperature X1Ts, and the particle is at least one of a metal particle and an inorganic compound particle.

The second polypropylene film of the present invention is a polypropylene film containing a particle, in which an aspect ratio of the particle observed in a cross section cut along a plane parallel to a Y1 direction and perpendicular to a thickness direction is 2 or more where a direction orthogonal in a film plane to a direction in which a shrinkage ratio is largest at 140°C in a temperature increase process of thermomechanical analysis (TMA) is defined as the Y1 direction, and the particle is at least one of a metal particle and an inorganic compound particle.

### EFFECTS OF THE INVENTION

The present invention can provide a polypropylene film having excellent thermal dimensional stability, and high oxygen barrier properties and water vapor barrier properties even while using a recycled deposited film.

### EMBODIMENTS OF THE INVENTION

Hereinafter, first and second polypropylene films of the present invention will be described in detail. Hereinafter, when the upper limits and the lower limits of preferable ranges are described separately, the limits can be arbitrarily combined. The first and second polypropylene films of the present invention may be collectively referred to as the present invention or the polypropylene film of the present invention. In the present specification, hereinafter, the polypropylene film may be simply referred to as a film, and the water vapor barrier properties and the oxygen barrier properties may be collectively referred to as "barrier properties".

The first polypropylene film of the present invention is a polypropylene film containing particles, in which a temperature X1Ts is 100°C or more and 160°C or less where a direction in which a shrinkage ratio is largest at 140°C in a temperature increase process of thermomechanical analysis (TMA) is defined as an X1 direction, and a temperature at which a 1% shrinkage occurs in the X1 direction is defined as the temperature X1Ts, and the particles are at least one of metal particles and inorganic compound particles.

The second polypropylene film of the present invention is a polypropylene film containing particles, in which an aspect ratio of the particles observed in a cross section cut along a plane parallel to a Y1 direction and perpendicular to a thickness direction is 2 or more where a direction orthogonal in a film plane to a direction in which a shrinkage ratio is largest at 140°C in a temperature increase process of thermomechanical analysis (TMA) is defined as the Y1 direction, and the particles are at least one of metal particles and inorganic compound particles.

In the present invention, the polypropylene film refers to an article formed into a sheet shape containing 60% by mass or more and 100% by mass or less of a polypropylene-based resin when all the constituent components are taken as 100% by mass. The polypropylene-based resin refers to a resin in which a propylene unit accounts for 90 mol% or more and 100 mol% or less when all the constituent units constituting the resin are taken as 100 mol%.

For the first polypropylene film of the present invention, it is important that the temperature X1Ts is 100°C or more and 160°C or less where a direction in which a shrinkage ratio is largest at 140°C in a temperature increase process of thermomechanical analysis (TMA) is defined as the X1 direction, and a temperature at which a 1% shrinkage occurs in the X1 direction is defined as the temperature X1Ts. The temperature X1Ts of the polypropylene film being 100°C or more means that the polypropylene film is excellent in thermal dimensional stability at a high temperature. Therefore, when the temperature X1Ts of the polypropylene film is 100°C or more, for example, when a layer (hereinafter referred to as a D layer) containing a metal and an inorganic compound in a total amount of more than 50% by mass and 100% by mass or less is laminated on at least one surface of the polypropylene film described later by vapor deposition, defects such as pinholes and cracks formed in the D layer due to shrinkage of the polypropylene film due to heat during vapor deposition can be reduced, and the water vapor barrier properties and the oxygen barrier properties of the laminate in which the D layer is laminated can be improved. In addition, since shrinkage of the polypropylene film due to a high temperature treatment such as a heat sterilization treatment performed after bag-forming processing is suppressed, deterioration of water vapor barrier properties and oxygen barrier properties associated with such a treatment can also be reduced. On the other hand, in order to make the temperature X1Ts of the polypropylene film higher than 160°C, it is necessary to use a raw material having high crystallinity and to perform biaxial stretching at a high area magnification during film formation, and the upper limit of the temperature X1Ts is set to 160°C from the viewpoint of poor productivity such as film breakage during film formation.

From the above viewpoint, the lower limit of the temperature X1Ts of the first polypropylene film of the present invention is preferably 105°C, more preferably 111°C, still more preferably 115°C, particularly preferably 121°C or more. On the other hand, the upper limit of the temperature X1Ts is preferably 159°C or less, more preferably 158°C or less.

A method for setting the temperature X1Ts of the polypropylene film to 100°C or more and 160°C or less is not particularly limited, and examples thereof include a method of adjusting the preheating temperature and the stretching temperature in the width direction and the relaxation ratio in the heat treatment step during film formation of the polypropylene film. More specifically, the preheating temperature in the width direction is set to the width direction stretching temperature + 1°C or more, more preferably + 2°C or more, still more preferably + 3°C or more, most preferably + 4°C or more, and the relaxation ratio in the heat treatment step is set to 5% or more, more preferably 8% or more, still more preferably 11% or more.

The temperature X1Ts can be measured using a known thermomechanical analyzer (such as TMA/SS6000 (manufactured by Seiko Instruments Inc.)), and a detailed procedure and each condition such as a temperature condition, a load condition, and a test length in the case of using the thermomechanical analyzer will be described later in the Examples section. The same applies to measurement of a temperature X2Ts to be described later.

It is important that the polypropylene film of the present invention contains particles. Here, the particles are at least one of metal particles and inorganic compound particles. By dispersing the particles in the polypropylene film, high barrier properties and lubricity of the film surface can be realized.

From the above viewpoint, as the particles in the polypropylene film of the present invention, for example, any one of aluminum, an inorganic oxide (such as aluminum oxide (may be referred to as alumina), silicon oxide such as silica, cerium oxide, and calcium oxide), a diamond-like carbon film, and a mixture thereof is suitably used, the inorganic oxide is more preferable, and at least one of alumina, silica, and an oxide of aluminum and silicon is particularly preferably contained. The alumina, silica, and an oxide of aluminum and silicon include partially oxidized products in addition to complete oxides.

The type of the particles can be identified, for example, by performing energy dispersive X-ray analysis (EDS) and electron energy loss spectroscopy (EELS) analysis using GATAN GIF "Tridiem" as necessary. In the EELS analysis, the component of the particles can be identified by collating the obtained EELS spectrum with the EELS spectrum of a commercially available metal compound or publicly available EELS spectrum data. As a measuring device, JED-2300F (semiconductor detector, DrySD Extra, manufactured by JEOL Ltd.) or the like can be used for EDS, and a field emission transmission electron microscope JEM-2100F (manufactured by JEOL Ltd., acceleration voltage 200 kV) or the like can be used for EELS analysis.

In the second polypropylene film of the present invention, it is important that an aspect ratio of the particles observed in a cross section cut along a plane parallel to the Y1 direction and perpendicular to the thickness direction is 2 or more where a direction orthogonal in a film plane to a direction in which a shrinkage ratio is largest at 140°C in a temperature increase process of thermomechanical analysis (TMA) is defined as the Y1 direction. Hereinafter, the "aspect ratio of the particles observed in a cross section cut along a plane parallel to the Y1 direction and perpendicular to the thickness direction" may be simply referred to as an "aspect ratio of the Y1 cross section". The particles having an aspect ratio of the Y1 cross section of 2 or more as used herein are usually highly flat particles, and the barrier properties of the polypropylene film can be enhanced by dispersing the highly flat particles in the form of a layer. In addition, the barrier properties can be further enhanced by bringing the major axis direction of the particles close to parallel to the film surface. Here, the major axis refers to the direction of the long side when a particle is surrounded by a rectangle having the smallest area.

The aspect ratio of the Y1 cross section is more preferably 5 or more, still more preferably 10 or more, still more preferably 30 or more, particularly preferably 50 or more because higher barrier properties can be exhibited as the particles become flatter and are dispersed in a form closer to a layer. The upper limit of the aspect ratio is not particularly limited but is set to 500. The method for setting the aspect ratio of the Y1 cross section of the particles in the polypropylene film to 2 or more is not particularly limited, and examples thereof include a method in which a polypropylene film is formed using a raw material obtained by melting and re-pelletizing a laminate having a polypropylene layer described later and a layer (D layer) containing a metal and an inorganic compound in a total amount of more than 50% by mass and 100% by mass or less, and in this case, the D layer in the laminate is preferably thin. In addition, stretching is effective to disperse the particles in the form of a layer and bring the major axis direction close to parallel to the film surface.

Also in the first polypropylene film, the aspect ratio (aspect ratio of the Y1 cross section) of the particles observed in a cross section cut along a plane parallel to the Y1 direction and perpendicular to the thickness direction can be 2 or more where a direction orthogonal in a film plane to a direction (X1 direction) in which a shrinkage ratio is largest at 140°C in a temperature increase process of thermomechanical analysis (TMA) is defined as the Y1 direction, and the same means for achieving the aspect ratio can be used. That is, the first polypropylene film may include a mode of the second polypropylene film.

In the first polypropylene film of the present invention, from the viewpoint of exhibiting high barrier properties, the aspect ratio of the particles observed in the cross section cut along a plane parallel to the X1 direction and perpendicular to the thickness direction is preferably 2 or more. Hereinafter, the "aspect ratio of the particles observed in a cross section cut along a plane parallel to the X1 direction and perpendicular to the thickness direction" may be simply referred to as an "aspect ratio of the X1 cross section". The aspect ratio of the X1 cross section is more preferably 5 or more, still more preferably 10 or more, still more preferably 30 or more, particularly preferably 50 or more because higher barrier properties can be exhibited as the particles become flatter and are dispersed in a form closer to a layer. The upper limit of the aspect ratio of the X1 cross section is not particularly limited but is set to 500.

The method for setting the aspect ratio of the X1 cross section of the particles in the polypropylene film to 2 or more is not particularly limited, and examples thereof include a method in which particles having an aspect ratio of 2 or more are dispersed in a polypropylene resin in advance and added at the time of film formation, and a method in which a polypropylene film is formed using a raw material obtained by melting and re-pelletizing a laminate having a polypropylene layer described later and a layer (D layer) containing a metal and an inorganic compound in a total amount of more than 50% by mass and 100% by mass or less, and in this case, the D layer in the laminate is preferably thin. In addition, stretching is effective to disperse the particles in the form of a layer and bring the major axis direction close to parallel to the film surface. The aspect ratio of the X1 cross section, the aspect ratio of the Y1 cross section, and the length of the short side of the particles (to be described later) can be measured and calculated using a cross-sectional image acquired by observation with a scanning electron microscope (SEM), and the details thereof will be described later.

In the polypropylene film of the present invention, from the viewpoint that high barrier properties can be exhibited by dispersing highly flat particles in a film in the form of a layer with the major axis direction close to parallel to the film surface, the length of the short side of the particles observed in a cross section cut along a plane parallel to the X1 direction and perpendicular to the thickness direction is preferably less than 100 nm. From the above viewpoint, the length of the short side of the particles is more preferably 50 nm or less, still more preferably 30 nm or less, still more preferably 20 nm or less, particularly preferably 10 nm or less. As a method for setting the length of the short side of the particles in the polypropylene film to less than 100 nm, the same method as the method for setting the aspect ratio of the X1 cross section of the particles in the polypropylene film to 2 or more can be used.

In addition, in the polypropylene film of the present invention, also in a cross section cut along a plane parallel to the Y1 direction and perpendicular to the thickness direction, from the same viewpoint, the length of the short side of the particles is preferably less than 100 nm or in the above preferable range. As a method for satisfying the requirement, for example, the same method as the method for setting the aspect ratio of the Y1 cross section of the particles in the polypropylene film to 2 or more can be used.

The polypropylene film of the present invention preferably has a total light transmittance of more than 70% and less than 100% from the viewpoint of ensuring the visibility of contents when used as a packaging material. Here, the total light transmittance is the total light transmittance when light is perpendicularly incident on the film surface, in other words, the total light transmittance in the film thickness direction. From the above viewpoint, the total light transmittance is preferably 75% or more, more preferably 80% or more, still more preferably 85% or more, particularly preferably 90% or more. Furthermore, the total light transmittance is set to less than 100% in consideration of feasibility. The total light transmittance can be measured with a known haze meter such as a haze meter (HGM-2DP) manufactured by Suga Test Instruments Co., Ltd.

The method for setting the total light transmittance of the polypropylene film to more than 70% and less than 100% is not particularly limited, and examples thereof include a method of adjusting the total light transmittance by the type of metal particles or inorganic compound particles contained in the film described later, the aspect ratio of the Y1 cross section, or the aspect ratio of the Y1 cross section. More specifically, the total light transmittance of the polypropylene film can be increased by using particles of the above-described type (particularly particles having high transparency such as AlOx) and having a large aspect ratio.

In the polypropylene film of the present invention, it is preferable that the average roughness (Sa) of at least one surface measured by three-dimensional non-contact surface profile measurement be 30 nm or less, and the root mean square height (Sq) be 50 nm or less. Here, "the average roughness (Sa) of at least one surface is 30 nm or less and the root mean square height (Sq) is 50 nm or less" means that the average roughness (Sa) and the root mean square height (Sq) are in the above ranges on the same plane. Here, the average roughness (Sa) of the surface refers to an Sa value measured by three-dimensional non-contact surface profile measurement. Hereinafter, the average roughness (Sa) of the surface value may be referred to as Sa or Sa value. Here, both the average roughness (Sa) and the root mean square height (Sq) are parameters derived as the arithmetic average roughness defined in ISO 25178 (2012).

By setting the Sa value of at least one surface to 30 nm or less, the polypropylene film surface becomes sufficiently smooth, and as a result, when the D layer to be described later including the vapor-deposited layer is laminated, the thickness of the D layer can be made uniform, and defects such as pinholes and cracks in the D layer can be reduced. Therefore, the water vapor barrier properties and the oxygen barrier properties of the laminate in which the D layer is laminated can be improved. From the above viewpoint, the upper limit of the Sa value of at least one surface is more preferably 24 nm. In addition, the lower limit of the Sa value is not particularly limited, but is 10 nm from the viewpoint of imparting appropriate slipperiness to the polypropylene film and improving the conveyance property.

The root mean square height (Sq) represents the root mean square at a reference length and means the standard deviation of the surface roughness. Hereinafter, the root mean square height (Sq) of the surface measured by three-dimensional non-contact surface profile measurement may be referred to as Sq or Sq value. That is, the Sq value is a numerical value that is emphasized when there is a mountain with high unevenness on the film surface. By setting the Sq value of at least one surface of the film to 50 nm or less, the film surface becomes a smooth surface with no local coarse projection or the like, and as a result, when the D layer to be described later including the vapor-deposited layer is laminated, the thickness of the D layer can be made uniform, and defects such as pinholes and cracks in the D layer can be reduced. Therefore, the water vapor barrier properties and the oxygen barrier properties of the laminate in which the D layer is laminated can be improved. From the above viewpoint, the upper limit of the Sq value of at least one surface is more preferably 48 nm, still more preferably 46 nm, particularly preferably 44 nm, most preferably 30 nm. In addition, the lower limit of the Sq value is not particularly limited, but is 10 nm from the viewpoint of imparting appropriate slipperiness to the polypropylene film and improving the conveyance property.

Examples of the method for setting the Sa value of at least one surface of the polypropylene film to 30 nm or less or within the above preferable range and controlling the Sq value to 50 nm or less or within the above preferable range include, but are not particularly limited to, a method of adding, as a raw material for a layer on the surface on the side on which the D layer is laminated, a polypropylene-based resin including more than 0% by mass and 5% by mass or less of a branched structure, a crystal nucleating agent, and an olefin-based resin incompatible with polypropylene in addition to a linear polypropylene-based resin, a method of setting the temperature of the casting drum to 30°C or less, and an adjusting method by increasing the preheating temperature before stretching in the longitudinal direction and the preheating temperature before stretching in the width direction and decreasing the stretching temperature during formation of the polypropylene film. Note that these methods can be used in appropriate combination.

The value Sa and the value Sq can be measured with a known three-dimensional non-contact surface profile measuring instrument (e.g., a scanning white-light interference microscope from Hitachi High-Tech Science Corporation) and an analysis system attached thereto, and the detailed measurement conditions and analysis conditions are described in the Examples section.

For the polypropylene film of the present invention, the peak melting temperature (Tm) of a film obtained by heating the film from 30°C to 260°C at 20°C/min with a differential scanning calorimeter DSC is preferably 160°C or more. By setting the temperature Tm to 160°C or more, more preferably 163°C or more, still more preferably 166°C or more, still more preferably 169°C or more, particularly preferably 172°C or more, crystallinity is kept high, so that deformation of the polypropylene film due to heat during vapor deposition is reduced. That is, when the D layer to be described later is laminated by vapor deposition, defects such as pinholes and cracks in the D layer are reduced, and the barrier properties of the laminate in which the D layer is laminated are enhanced. The method for controlling the temperature Tm within the above-mentioned range is not particularly limited, and examples thereof include a method in which a polypropylene resin having a high melting point is contained, and the stretching ratios in the longitudinal direction and the width direction are adjusted during film formation of a polypropylene film as described later. More specifically, this can be achieved by setting the melting point of the polypropylene-based resin to 150°C or more and the stretching ratio in the longitudinal direction during film formation to 2.0 times or more and 15 times or less, preferably 4.0 times or more and 10 times or less, more preferably 4.3 times or more and 8.0 times or less, further preferably 4.6 times or more and 6.0 times or less, and setting the stretching ratio in the width direction to 7.0 times or more and 20 times or less, more preferably 8.0 times or more and 16 times or less, further preferably 8.5 times or more and 12 times or less.

The polypropylene film of the present invention preferably has a b value* of -2.00 or more and 2.00 or less as measured with a spectral color difference meter from the viewpoint of ensuring the visibility of contents when used as a packaging material, where the b value* represents the strength of color tone from blue to yellow, the - (minus) value represents the strength of blueness, and the + (plus) value represents the strength of yellowness. For both values, the larger the absolute value is, the stronger the color tone is. From the above viewpoint, the lower limit of the b value* is more preferably -1.50, still more preferably -1.00, still more preferably -0.50, while the upper limit is more preferably 1.50, still more preferably 1.00, still more preferably 0.50.

The method for controlling the b value* within the above range is not particularly limited, but for example, in a melting step of melting a laminate including a polypropylene layer to be described later and a layer (D layer) containing a metal and an inorganic compound in a total amount of more than 50% by mass and 100% by mass or less, nitrogen gas is injected to reduce the oxygen concentration in this step and suppress oxidative deterioration of the polypropylene-based resin, so that a change in which the resin itself turns brown can be prevented. Note that the b value* can be measured with a known spectrocolorimeter, and as a measuring device, for example, a spectrocolorimeter CM-3600d manufactured by KONICA MINOLTA SENSING, INC. can be used. A measurement method when the device is used will be described later.

### <Laminate>

Subsequently, the laminate of the present invention will be described. The laminate of the present invention includes the layer (D layer) containing a metal and an inorganic compound in a total amount of more than 50% by mass and 100% by mass or less on at least one surface of the polypropylene film of the present invention. Here, the "layer containing a metal and an inorganic compound in a total amount of more than 50% by mass and 100% by mass or less" refers to a layer containing only the metal in the amount of more than 50% by mass, a layer containing only the inorganic compound in the amount of more than 50% by mass, and a layer containing both the metal and the inorganic compound in the total amount of more than 50% by mass, when all the components constituting the layer are taken as 100% by mass. As the metal and/or the inorganic compound of the D layer, for example, any of aluminum, an inorganic oxide (such as aluminum oxide, silicon oxide, cerium oxide, and calcium oxide), a diamond-like carbon film, or a mixture thereof is suitably used from the viewpoint of improving the adhesion to the polypropylene film, improving the gas barrier properties when laminated on the polypropylene film, and reducing environmental burden. Among them, the inorganic oxide described above is more preferable, and at least one of alumina, silica, and an oxide of aluminum and silicon is particularly preferable.

Here, when the polypropylene film has a laminated configuration, the D layer is preferably formed on a surface of a layer (hereinafter referred to as an A layer) that forms a surface (a-surface) in which the average roughness (Sa) and the root mean square height (Sq) of the surface measured by three-dimensional non-contact surface profile measurement of the surface of the polypropylene film are small. By adopting such a mode, high water vapor barrier properties and oxygen barrier properties can be realized. In addition, a resin layer having a thickness of 1 um or less may be provided between the D layer and the A layer by coating or the like. By providing such a resin layer, an effect of improving the adhesion between the D layer and the A layer may be obtained. However, from the viewpoint of production cost and recyclability, a mode without the resin layer (that is, a mode in which the D layer is directly laminated on the a-surface formed by the A layer) is preferable.

Examples of a method for forming the D layer on the polypropylene film of the present invention to form the laminate include coating, vapor deposition, and lamination. The vapor deposition is particularly preferable because it is not dependent on humidity and an excellent gas barrier properties can be expressed by a thin film. As the vapor deposition method, physical vapor deposition methods such as a vacuum vapor deposition method, an EB vapor deposition method, a sputtering method, and an ion plating method, and various chemical vapor deposition methods such as plasma CVD can be used. The vacuum vapor deposition method is particularly preferably used from the viewpoint of productivity.

A water vapor transmission rate of the laminate of the present invention is preferably 2.0 g/m²/day or less from the viewpoint of the preservability of contents when the laminate is used as a packaging material. The water vapor transmission rate is more preferably 1.0 g/m²/day or less, still more preferably 0.5 g/m²/day or less. By adopting such a range, it is possible to reduce a deterioration due to moisture absorption or moisture release of contents particularly when the laminate is used in food packaging applications.

As a method for setting the water vapor transmission rate of the laminate of the present invention to 2.0 g/m²/day or less or the above preferable range, for example, a method for setting the temperature X1Ts of a polypropylene film used for the laminate to 100°C or more and 160°C or less, a method for setting the aspect ratio of the Y1 cross section to 2 or more, that is, a method using the polypropylene film of the present invention for the laminate, or the like can be suitably used.

In addition, an oxygen transmission rate of the laminate of the present invention is preferably 200 cc/m²/day or less from the viewpoint of the preservability of contents when the laminate is used as a packaging material. From the above viewpoint, the oxygen transmission rate of the laminate of the present invention is more preferably 100 cc/m²/day or less, more preferably 10 cc/m²/day or less, still more preferably 2.0 cc/m²/day or less, particularly preferably 1.0 cc/m²/day or less, most preferably 0.5 cc/m²/day or less. By adopting such a range, it is possible to reduce a deterioration due to oxidation of contents particularly when the laminate is used in food packaging applications.

The method for setting the oxygen transmission rate of the laminate to 200 cc/m²/day or less or in the above preferable range is not particularly limited, and examples thereof include a method using the polypropylene film of the present invention for the laminate. In addition, it is also effective to use a method of laminating a topcoat layer containing an organic-inorganic mixture on the surface of the D layer in order to suppress the oxygen transmission rate of the laminate. Preferable examples of the topcoat layer include, as one thereof, a mixture of; an alkoxide containing a metal or a silicon atom and/or a polycondensate thereof; and a water-soluble polymer. These methods can be used in combination as appropriate.

The total light transmittance of the laminate of the present invention is preferably more than 70% and less than 100% from the viewpoint of obtaining the visibility of the contents when used as a packaging material. The total light transmittance is more preferably 80% or more, more preferably 83% or more, still more preferably 86% or more, particularly preferably 89% or more, most preferably 92% or more. Furthermore, the total light transmittance is set to less than 100% in consideration of feasibility. The method for making the total light transmittance of the laminate more than 70% and less than 100% is not particularly limited, but can be achieved by using, for example, any of aluminum oxide, silicon oxide, cerium oxide, calcium oxide, a diamond-like carbon film, and a mixture thereof as the inorganic compound for the D layer.

The thickness of the D layer in the laminate of the present invention is preferably 200 nm or less from the viewpoint of recycling properties of reusing the laminate as a resin or a film, improving barrier properties by making the laminate difficult to crack, and obtaining visibility of contents when the laminate is used as a packaging material. The thickness is more preferably 110 nm or less, still more preferably 50 nm or less, still more preferably 30 nm or less. The lower limit is not particularly limited, but is set to 1 nm from the viewpoint of exhibiting barrier properties.

For the laminate of the present invention, it is preferable that the temperature X2Ts be 100°C or more and 160°C or less where a direction in which a shrinkage ratio is largest at 140°C in a temperature increase process of thermomechanical analysis (TMA) is defined as a X2 direction, and a temperature at which a 0.1% shrinkage occurs in the X2 direction is defined as the temperature X2Ts. With such a mode, when a high-temperature treatment such as a heat sterilization treatment is performed after bag-forming processing, it is possible to inhibit the shrinkage of the polypropylene film and to prevent the deterioration in the water vapor barrier properties and the oxygen barrier properties. From the above viewpoint, the lower limit of the temperature X2Ts of the polypropylene film is 100°C, preferably 105°C, more preferably 111°C, still more preferably 115°C, most preferably 121°C. On the other hand, the upper limit of the temperature X2Ts is 160°C, preferably 159°C, more preferably 158°C. As a method for setting the temperature X2Ts to 100°C or more and 160°C or less, for example, the same method as the method for setting the temperature X1Ts to 100°C or more and 160°C or less can be used. More specifically, the D layer is formed on the polypropylene film obtained by the method for setting the temperature X1Ts to 100°C or more and 160°C or less.

### <Packaging material and packaged body>

Hereinafter, a packaging material and a packaged body of the present invention will be described. The packaging material of the present invention includes at least one of the polypropylene film of the present invention and the laminate of the present invention. The packaging material of the present invention is excellent in structural stability to heat during vapor deposition, and has a favorable water vapor barrier properties and oxygen barrier properties particularly when the transparent vapor-deposited layer is laminated, so that the packaging material can be suitably used for packaging those easily deteriorated by water vapor or oxygen.

The packaged body of the present invention includes contents packed using the packaging material of the present invention. The contents are not particularly limited. Since the packaging material of the present invention is excellent in transparency, water vapor barrier properties, and oxygen barrier properties, the contents preferably require visibility from the outside, and are easily deteriorated by water vapor or oxygen. Note that the packaged body of the present invention is obtained by covering the contents with the packaging material of the present invention, and a mode thereof is not particularly limited. Examples thereof include a packaged body obtained by processing the packaging material of the present invention into a bag shape by heat sealing and putting contents into the bag. Specific examples of such a packaged body include retort pouch food products.

### <Manufacturing method>

Hereinafter, a method for manufacturing the polypropylene film of the present invention will be described.

A method for manufacturing a polypropylene film of the present invention includes, in this order, a melting step of melting a laminate including a polypropylene layer and a layer (D layer) containing a metal and an inorganic compound in a total amount of more than 50% by mass and 100% by mass or less, a casting step of melting a mixed resin containing 1% by mass or more and 99% by mass or less of a melt obtained in the melting step and ejecting the melted resin into a sheet from a die, and cooling and solidifying the melted resin on a support to obtain a polypropylene sheet, a stretching step of stretching the polypropylene sheet in two orthogonal directions, and a heat treatment step of subjecting the film obtained in the stretching step to a heat treatment and a relaxation treatment. The layer configuration of the polypropylene film of the present invention is not particularly limited, and for example, a two-type two-layer configuration of A layer/B layer, a two-type three-layer configuration of A layer/B layer/A layer, a three-type three-layer configuration of A layer/B layer/C layer (here, the C layer means a layer different from the A layer and the B layer), or the like can be adopted. Hereinafter, the method for manufacturing the polypropylene film having a three-type three-layer structure including the A layer, the B layer, and the C layer will be described more specifically as an example, but the polypropylene film of the present invention and the method for manufacturing the polypropylene film are not interpreted as being necessarily limited thereto.

First, a laminate including a polypropylene layer and a layer containing a metal and an inorganic compound in a total amount of more than 50% by mass and 100% by mass or less is melted, kneaded, and extruded, and then the strand is cooled with water and formed into chips to obtain a polypropylene-based resin raw material. Next, a mixed resin mixed with a polypropylene-based resin so as to contain 1% by mass or more and 99% by mass or less of the obtained polypropylene-based resin raw material is melted with a single-screw extruder for the B layer, a polypropylene-based resin or a polypropylene-based resin composition as a raw material of the A layer is melted with a single-screw extruder for the A layer, and a polypropylene-based resin or a polypropylene-based resin composition as a raw material of the C layer having a melting point lower than that of the B layer is melted with a single-screw extruder for the C layer. Melt-extrusion is performed from separate single screw extruders set at extrusion temperatures of 220°C to 280°C, preferably 230°C to 270°C, and foreign matters and the like are removed by passing the materials through a filtration filter. It is preferable that particles having a small particle size be added to at least one surface layer, and it is more preferable that an olefin-based resin incompatible with polypropylene be added to at least one surface layer. By adopting such a mode, the surface of the obtained polypropylene film is made sufficiently smooth, the thickness of the D layer is made uniform when laminating the D layer described later including the vapor-deposited layer, and defects such as pinholes and cracks in the D layer are reduced, whereby the water vapor barrier properties and the oxygen barrier properties of the laminate can be enhanced. Subsequently, these molten resins are joined with a feedblock or the like so as to have a desired layer configuration (when the raw materials for the A, B, and C layers in the melting stage are defined as a, b, and c, respectively, for example, a/b/c or the like). Thereafter, the obtained molten resin is extruded from a slit-shaped die at a temperature of 200°C to 260°C.

Next, the molten resin sheet extruded from the slit-shaped die is cooled for solidification on a casting drum (cooling drum) with a surface temperature controlled to 10°C to 40°C to obtain an unstretched polypropylene film. At this time, it is preferable to perform co-extrusion lamination such that the surface side on which the molten sheet extruded from the die first comes into contact with the drum becomes the A layer because the surface roughness parameter of the A layer can be easily controlled within a desired range. As a method for bringing the molten sheet into close contact with the casting drum, any of an electrostatic application method, an adhesion method using the surface tension of water, an air knife method, a press roll method, an underwater casting method, an air chamber method, and the like may be used, or a plurality of methods may be combined. An air knife method capable of obtaining favorable film flatness and capable of controlling surface roughness is preferable. In addition, in the case of using the air knife method, it is preferable to appropriately adjust the position of the air knife such that the air flows to the downstream side of the film formation for keeping the film from vibrating.

From the viewpoint of smoothing the surface of the obtained polypropylene film and improving the thickness uniformity and adhesion of the D layer formed by the vapor-deposited film or the like, the surface temperature of the casting drum is preferably 10°C to 35°C, more preferably 10°C to 30°C, most preferably 10°C to 25°C, and the resin to be the A layer after stretching is preferably on the drum surface (surface in contact with the casting drum) side. By adopting such a temperature range and configuration, it is possible to increase the mesomorphic phase fraction of a surface layer portion particularly on the drum surface side (surface side to be the A layer after stretching) of the unstretched polypropylene film, so that the unstretched polypropylene film can have a mesomorphic phase structure.

The mesomorphic phase is an intermediate phase between a crystal and an amorphous phase, and is specifically produced in solidification at a very high cooling rate from a molten state. It is generally known that spherulites grow when a polypropylene is cooled and solidified into crystals. It is believed that when an unstretched polypropylene film having the spherulites is stretched, a difference in stretching stress is produced between the crystal portion and the amorphous portion inside the spherulites and between the spherulites, which produces local stretching unevenness, leading to thickness unevenness and structure unevenness. On the other hand, since the mesomorphic phase does not take a spherulite form, stretching unevenness does not occur, and stretching uniformity is enhanced, so that thickness uniformity becomes high, and surface roughness is small and easily becomes uniform when the mesomorphic phase is formed into a film.

Next, the unstretched polypropylene film is biaxially stretched to be biaxially oriented. First, the unstretched polypropylene film is preheated by passing the film between rolls with the lower limit preferably kept at 70°C, more preferably 80°C, and the upper limit preferably kept at 150°C, more preferably 140°C. At this time, by setting the preheating temperature to 120°C or more and the stretching temperature in the longitudinal direction + 2°C or more, more preferably + 3°C or more, still more preferably + 6°C or more, particularly preferably + 9°C or more and setting the stretching temperature in the longitudinal direction to a temperature lower than the preheating temperature in the longitudinal direction and 110°C or more, it is possible to regulate the anomalous spherulites on the front and back of the film of the drum surface (surface in contact with the casting drum) side and the drum opposite surface (surface not in contact with the casting drum) after stretching, and it is possible to form the drum surface side into a smooth surface and the drum opposite surface into a rough surface. Subsequently, the film is longitudinally stretched at a stretching ratio of 2.0 times or more and 15 times or less, preferably 4.0 times or more and 10 times or less, more preferably 4.3 times or more and 8.0 times or less, still more preferably 4.6 times or more and 6.0 times or less in the longitudinal direction while being maintained in the above-mentioned stretching temperature range, and then cooled to room temperature to obtain a uniaxially oriented film.

Subsequently, the uniaxially oriented film is guided to a tenter with the end of the film being grasped with a clip, and stretched in the width direction (laterally stretched) with the end of the film being grasped with the clip. At this time, the preheating temperature before stretching is set to the width-direction stretching temperature + 1°C or more, more preferably + 2°C or more, still more preferably + 3°C or more, particularly preferably + 4°C or more. By setting the preheating temperature before stretching to be higher than the width-direction stretching temperature, the stress at the initial stage of stretching in the width direction can be reduced, so that stretching unevenness does not occur and stretching uniformity is enhanced, and therefore the surface roughness of a polypropylene film is also small and tends to be uniform. The stretching temperature in the width direction is 150 to 170°C, preferably 155 to 165°C.

In addition, the stretching ratio in the width direction is preferably 7.0 times or more and 20 times or less, more preferably 8.0 times or more and 16 times or less, still more preferably 8.5 times or more and 12 times or less. By setting the stretching ratio in the width direction to 7.0 times or more, it is possible to impart high orientation in the width direction as well while maintaining a high orientation state in the longitudinal direction, and to increase molecular chain tension in the surface. Therefore, particularly when the film is used in packaging applications, the structural stability of the film to heat during vapor deposition can be enhanced, and a uniform vapor-deposited film can be formed, so that a favorable water vapor barrier properties and oxygen barrier properties can be obtained. In addition, by setting the stretching ratio in the width direction to 20 times or less, it is possible to prevent film breakage during film formation, and to improve productivity.

In the manufacture of the polypropylene film of the present invention, a heat treatment and a relaxation treatment are preferably performed after the lateral stretching. The heat treatment and the relaxation treatment are performed preferably at a temperature of 140°C or more and 170°C or less while relaxing the film by 2% or more and 20% or less in the width direction with the opposite ends in the width direction being tightly grasped with the clips of the tenter. The lower limit of the heat treatment temperature is preferably 152°C, more preferably 154°C, while the upper limit is preferably 168°C, more preferably 165°C. By performing such a heat treatment, it is possible to improve the structural stability of the film to heat, and to inhibit a heat defect phenomenon in which defects such as pinholes and cracks are formed in the D layer when the D layer is formed by vapor deposition to form the laminate. As a result, the water vapor barrier properties and the oxygen barrier properties of the laminate obtained from the polypropylene film can be improved. In the relaxation treatment, from the viewpoint of enhancing the structural stability of the film against heat, the lower limit of the relaxation ratio is preferably 5%, more preferably 8%, still more preferably 11%, while the upper limit is preferably 18%, more preferably 17%. When the relaxation ratio is less than 2%, the resulting polypropylene film may be poor in dimensional stability during heating. Therefore, when the D layer is formed by vapor deposition to form a laminate, the film is deformed to form defects such as pinholes and cracks in the D layer, and as a result, the water vapor barrier properties and the oxygen barrier properties of the laminate in which the D layer is laminated may be impaired. On the other hand, in the case where the relaxation ratio exceeds 20%, the film becomes excessively slack inside the tenter, resulting in wrinkles in the film after film formation, which may lead to a deterioration in mechanical characteristics and unevenness during vapor deposition.

After the heat treatment mentioned above, the film is cooled at a temperature of 50°C or more and less than the heat treatment temperature and guided to the outside of the tenter, the clips at the opposite ends in the width direction of the film are then released under a room temperature atmosphere, and the opposite edges in the width direction of the film are slit in a winder step. Thereafter, for the purpose of increasing the peel strength of the D layer, the surface on which the layer (D layer) containing a metal and an inorganic compound in a total amount of more than 50% by mass and 100% by mass or less is to be laminated (typically, the surface on the side in contact with the cast drum) is preferably subjected to an in-line surface modification treatment. Examples of the in-line surface modification treatment include a corona discharge treatment, or a plasma treatment, an ion beam treatment, or the like, in the air or in an atmosphere gas of oxygen, nitrogen, hydrogen, argon, a carbon dioxide gas, a silane gas, or a mixture thereof. In particular, as for the corona discharge treatment, it is effective to perform the treatment in an atmosphere gas with an oxygen concentration of 10% or less, preferably 50 or less, more preferably 1% or less, and as a specific mode of the atmosphere gas with an oxygen concentration of 1% or less, it is effective to employ a nitrogen gas, a carbon dioxide gas, or a mixture thereof, particularly a mixture of a nitrogen gas and a carbon dioxide gas. In addition, a method of combining the above-described corona discharge treatment in the atmosphere gas with the plasma treatment or the ion beam treatment is also effective. Performing the treatment in such an atmosphere allows a hydrophilic functional group to be efficiently introduced while inhibiting the generation of a low-molecular-weight product with polypropylene molecular chain scission at the film surface, thus facilitating the increased peel strength of the D layer. The film thus obtained can be wound into a roll form to obtain a polypropylene film constituting the laminate according to the present invention.

### EXAMPLES

Hereinafter, the present invention will be described in more detail with reference to examples, but the present invention is not limited to the following modes. It is to be noted that respective items were evaluated by the following method.

### [Methods for measuring characteristic values, methods for evaluating effects]

Methods for measuring characteristic values and methods for evaluating effects in the present invention are as follows.

### (1) Polypropylene film thickness

The thickness of the polypropylene film was measured at 10 optional points in an atmosphere of 23°C and 65% RH using a contact-type electronic micrometer (K-312A type) manufactured by ANRITSU CORPORATION. The arithmetic average value of the thicknesses at the 10 points was taken as the thickness (unit: um) of the polypropylene film.

### (2) Determination of X1 direction, temperature X1Ts at which a 1% shrinkage occurs in X1 direction

### <Measurement of thermal shrinkage ratio by thermomechanical analysis (TMA)>

A polypropylene film was prepared and cut into a rectangle having a width of 4 mm and a length of 50 mm as the long side with an arbitrary direction directed upward to obtain a sample <1>. In this case, the long side direction of the rectangular sample <1> was defined as 0°. Next, a sample <2> in the same size was collected such that the long side direction was directed in a direction rotated rightward by 15° from the 0° direction. Subsequently, samples <3> to <12> were collected in the same manner by similarly rotating the long side direction of the rectangular sample by 15° each. Next, each rectangular sample was pinched by a metal chuck so as to have a test length of 20 mm. Thereafter, the sample was set in the following thermomechanical analyzer, and a thermal shrinkage curve of the film with the test length kept constant was obtained under the following temperature conditions and load conditions. The same measurement was performed for each sample once, and the long side direction of the sample having the maximum shrinkage ratio at 140°C was defined as the X1 direction of the polypropylene film. In addition, the temperature at which a 1% shrinkage occurred was read from the thermal shrinkage curve of TMA in the X1 direction, and the temperature X1Ts at which a 1% shrinkage occurred in the X1 direction was determined. The method for determining the X2 direction and the temperature X2Ts at which a 1% shrinkage occurred in the X2 direction were the same except that the object to be measured was a laminate.
(Apparatus)
   · Apparatus: TMA/SS 6000 (manufactured by Seiko Instruments Inc.)
(Temperature conditions)
   · Initial temperature: 25°C, maximum temperature: 180°C, rate: 10°C/min
   · Retention: 10 minutes
   · Sampling time: 10 S/time
   · Nitrogen cooling: No
(Load conditions)
   · Control mode: F
   · Upper limit load during standby: 19.6 mN
   · Initial load: 19.6 mN
   · Load rate: 0.1 mN/min
   · Retention: 600 minutes.

### (3) Total light transmittance

A haze meter (HGM-2DP) manufactured by Suga Test Instruments Co., Ltd. Was used. A piece having a size of 6.0 cm × 3.0 cm was cut out from the polypropylene film, and a value of the total light transmittance in the film thickness direction (direction perpendicular to the film surface) was obtained from a measured value when measurement was performed with light incident perpendicularly to the surface of the polypropylene film. Five measurements were taken, and their average was adopted as the total light transmittance. The total light transmittance of the laminate was also measured in the same manner.

### (4) Aspect ratio of particles and length of short side of particles

Cross sections of the polypropylene film were cut out using a microtome along a plane parallel to the Y1 direction and perpendicular to the thickness direction and a plane parallel to the X1 direction and perpendicular to the thickness direction. The cut cross sections were observed with a SEM at a magnification of 10,000 times. Ten particles observed in the field of view were randomly selected. For each particle, a rectangle was drawn so as to include the entire particle and to minimize the area, and the average values of the lengths of the long sides and the short sides were calculated. Thereafter, the average value of the lengths of the long sides was divided by the average value of the lengths of the short sides to obtain the aspect ratio of the particles. When the number of particles was less than 10 in one field of view, observation was performed while changing the observation position of the cut cross section of the polypropylene film, and observation was performed until the number of observed particles reached 10.

### (5) Peak melting temperature (Tm) of film

With the use of a differential scanning calorimeter (EXSTAR DSC6220 manufactured by Seiko Instruments Inc.), 3 mg of the film sample was heated from 30°C to 260°C under the condition of 20°C/min in a nitrogen atmosphere. The peak temperature of the endothermic curve obtained in the case of increasing the temperature was regarded as the peak melting temperature (Tm) of the polypropylene film. When a plurality of peak temperatures can be observed, the temperature of the peak at the highest temperature was regarded as the peak melting temperature (Tm) of the polypropylene film.

### (6) Melting point of polypropylene-based resin

With the use of a differential scanning calorimeter (EXSTAR DSC6220 manufactured by Seiko Instruments Inc.), 3 mg of a polypropylene-based resin sample was heated from 30°C to 260°C under the condition of 20°C/min in a nitrogen atmosphere. Subsequently, the sample was held at 260°C for 5 minutes, and then cooled down to 30°C under the condition of 20°C/min. The sample was further held at 30°C for 5 minutes, and then heated from 30°C to 260°C under the condition of 20°C/min. The peak temperature of an endothermic curve obtained at the time of the temperature rise was set as a melting point of the polypropylene-based resin. In the case where a plurality of peak temperatures can be observed, the temperature of the peak at the highest temperature was set as the melting point of the polypropylene-based resin.

### (7) Average roughness (Sa) of surface and root mean square height (Sq)

The measurement of the Sa value and Sq value was performed with the use of a scanning white-light interference microscope VS1540 from Hitachi High-Tech Science Corporation, which is a three-dimensional non-contact surface profile measuring instrument. In addition, in analysis, with the use of attached analysis software, the undulation component was removed from a shot image by polynomial quartic approximation surface correction, then, the image was processed with a median (3 × 3) filter, and then subjected to interpolation processing (processing of compensating for pixels from which height data failed to be acquired, with height data calculated from surrounding pixels). The measurement conditions were as follows, and the measurement was performed on both surfaces of the film.
Manufacturer: Hitachi High-Tech Science Corporation
Apparatus name: Scanning white-light interference microscope VS1540
   · Measurement conditions: Objective lens 10×
Lens barrel 1×
Zoom lens 1×
Wavelength filter 530 nm white
   · Measurement mode: Wave
   · Measurement software: VS-Measure Version10.0.4.0
   · Analysis software: VS-Viewer Version10.0.3.0
   · Measurement area: 0.561 × 0.561 mm².

### (8) b value* of polypropylene film

A spectrocolorimeter CM-3600d manufactured by KONICA MINOLTA SENSING, INC. was used. Under the conditions of a target mask having a measurement diameter of ϕ 25.4 mm, the b* value in the transmission method by the SCI method was measured, and the average value at a number of n of 5 was obtained. The white calibration plate and the zero calibration box used in the calibration were as follows. Note that D65 was selected as the light source used in calculating the colorimetric value.
White calibration plate: CM-A103
Zero calibration box: CM-A104.

### (9) Water vapor barrier properties after Al vapor deposition or after AlOx vapor deposition

### <Al vapor deposition method>

A film roll was set in a vacuum vapor deposition apparatus equipped with a film traveling device, and brought into a state in which the pressure is highly reduced to 1.00 × 10⁻² Pa. Thereafter, on a cooling metal drum at 20°C, the polypropylene film was caused to travel while aluminum metal was heated and evaporated to form a vapor-deposited thin-film layer on the A layer. At this time, the vapor-deposited film was controlled to have a thickness of about 100 nm. After the vapor deposition, the inside of the vacuum vapor deposition apparatus was returned to normal pressure, the wound film was rewound, and aged at a temperature of 40°C for 2 days to obtain a laminate in which the vapor-deposited layer of Al (aluminum) was laminated on the film.

### <AlOx vapor deposition method>

A film roll was set in a vacuum vapor deposition apparatus equipped with a film traveling device, and brought into a state in which the pressure is highly reduced to 1.00 × 10⁻² Pa. Thereafter, on a cooling metal drum at 20°C, the polypropylene film was caused to travel while AlOx was reacted and evaporated while introducing an oxygen gas to form a vapor-deposited layer on the A layer. At this time, the vapor-deposited layer was controlled to have a thickness of about 20 nm. After the vapor deposition, the inside of the vacuum vapor deposition apparatus was returned to normal pressure, the wound film was rewound, and aged at a temperature of 40°C for 2 days to obtain a laminate in which the vapor-deposited layer of AlOx (aluminum oxide) was laminated on the polypropylene film.

### <Method for evaluating water vapor barrier properties>

The laminate obtained through the Al vapor deposition or the AlOx vapor deposition was measured under the conditions of a temperature of 40°C and a humidity of 90% RH using a water vapor transmission rate measuring apparatus "PERMATRAN-W" (registered trademark) 3/30 manufactured by MOCON/Modern Controls, Inc. The measurement was performed five times per sample, and the average value of the obtained values was calculated and taken as the water vapor transmission rate of the film (unit: g/m²/day). From the obtained water vapor transmission rate, the water vapor barrier properties of the laminate was determined according to the following criteria. A or more was regarded as good water vapor barrier properties, and B was regarded as a practically acceptable level.
S: 0.5 g/m²/day or less.
A: More than 0.5 g/m²/day and 1.0 g/m²/day or less.
B: More than 1.0 g/m²/day and 2.0 g/m²/day or less.
C: More than 2.0 g/m²/day.

### (10) Oxygen barrier properties after Al vapor deposition or after AlOx vapor deposition

The laminate in which the Al vapor-deposited layer or the AlOx vapor-deposited layer was laminated was obtained by the method described in (9). For each laminate, the oxygen transmission rate was measured under the conditions of a temperature of 23°C and a humidity of 0% RH using an oxygen transmission rate measuring apparatus "OX-TRAN" (registered trademark) 2/20 manufactured by MOCON/Modern Controls, Inc. The measurement was performed 5 times per sample, and the average value of the obtained values was calculated and taken as the oxygen transmission rate of the film (unit: cc/m²/day). From the obtained oxygen transmission rate, the oxygen barrier properties of the laminate was determined according to the following criteria. A or more was regarded as good oxygen barrier properties, and B was regarded as a practically acceptable level.
S: 2.0 cc/m²/day or less.
A: More than 2.0 cc/m²/day and 10 cc/m²/day or less.
B: More than 10 cc/m²/day and 100 cc/m²/day or less.
C: More than 100 cc/m²/day.

### (11) Thickness of laminate

The laminate in which the Al vapor-deposited layer or the AlOx vapor-deposited layer was laminated was obtained by the method described in (9). The thickness was measured at any 10 points under an atmosphere at 23°C and 65% RH with the use of a contact-type electronic micrometer (K-312A type) manufactured by ANRITSU CORPORATION. The arithmetic average value of the thicknesses at the 10 points was regarded as the thickness (unit: um) of the laminate. It is to be noted that the accuracy (unit: um) of the thickness obtained by this measurement method is up to the first decimal place, and the thickness of the D layer was measured separately by the method of (12).

### (12) Thickness of D layer

The thickness of the D layer constituting the laminate according to the present invention was measured by cross-sectional observation with a transmission electron microscope (TEM). A sample for the cross-sectional observation was prepared by an FIB method with the use of Microsampling System (FB-2000A, manufactured by Hitachi, Ltd.) (specifically, according to the method described in "Kobunshi Hyomen Kakogaku" (Polymer Surface Processing)", Satoru Iwamori, pp. 118-119). Subsequently, a cross section of the sample for observation was observed with a TEM (H-9000UHRII, manufactured by Hitachi, Ltd.) at an accelerating voltage of 300 kV, and the thickness of the D layer was checked at arbitrary 10 points. The arithmetic average value of the thicknesses was regarded as the thickness (unit: nm) of the D layer.

### [Components for use in manufacture of polypropylene films according to examples and comparative examples]

The following components were used for the manufacture of polypropylene-based resin films constituting laminates according to examples and comparative examples.

### (Polypropylene-based resin for A layer)

A1: Homopolypropylene resin ("F113G" (meso-pentad fraction: 0.94, melting point: 162°C, MFR: 2.9 g/10 min) manufactured by Prime Polymer Co., Ltd.)

### (Masterbatch for A layer)

AM1: Masterbatch prepared by kneading and extruding A1 (90 parts by mass), a polymethylpentene-based resin 1 (10 parts by mass), and an antioxidant (0.1 parts by mass) with an extruder set at 260°C, then cooling the strand with water, and forming the strand into chips.

### (Polypropylene-based resin for B layer)

B1: Homopolypropylene-based resin ("F133A" manufactured by Prime Polymer Co., Ltd., melting point: 167°C, MFR: 3.0 g/10 min)

### (Masterbatch for B layer)

BM1: Masterbatch prepared by kneading and extruding B1 (70 parts by mass), a petroleum resin 1 (30 parts by mass), and an antioxidant (0.1 parts by mass) with an extruder set at 240°C, then cooling the strand with water, and forming the strand into chips.

### (Polypropylene-based resin for C layer)

C1: Ethylene-propylene random copolymer ("WFW4M" manufactured by Japan Polypropylene Corporation, melting point: 135°C, MFR: 7.0 g/min)

### (Masterbatch for C layer)

CM1: Masterbatch prepared by kneading and extruding C1 (90 parts by mass), the polymethylpentene-based resin 1 (10 parts by mass), and an antioxidant (0.1 parts by mass) with an extruder set at 260°C, then cooling the strand with water, and forming the strand into chips.

### (Resins other than polypropylene-based resin)

Polymethylpentene-based resin 1: "TPX" (registered trademark) (RT31, melting point 232°C, MFR: 9 g/10 min @260°C) manufactured by Mitsui Chemicals, Inc.

Petroleum resin 1: T-REZ HA125 (manufactured by JXTG Energy Corporation, softening point 125°C)

### (Particles, additives, etc.)

P1: Crosslinked particles (PMMA particles) of a polymethacrylic acid-based polymer of 2 um in average particle diameter.

P2: Silica particles of 300 nm in average particle diameter.

Antioxidant: "IRGANOX" (registered trademark) 1010 manufactured by Ciba Specialty Chemicals.

### (Example 1)

### (Production of laminate)

As a polypropylene-based resin raw material for the A layer, a mixture of A1 and AM1 at a mass ratio of 60 : 40 was used. In addition, as a raw material for the B layer, a mixture of B1 and BM1 at a mass ratio of 75 : 25 was used. Furthermore, as a raw material for the C layer, a mixture of C1 and CM1 at a mass ratio of 60 : 40 was used. The raw materials for the respective layers were supplied to an extruder (A), an extruder (B), and an extruder (C), which were separate single-screw extruders, to perform melt extrusion at 260°C, foreign matters were removed with an 80 um cut sintered filter, and then, the resin was passed through a pipe set at 260°C. Thereafter, the amount of extrusion was adjusted such that the lamination ratio was 1/10/1 in three-layer lamination of albic (compositions for the A to C layers in a molten state were referred to as a to c in order) with the use of a feedblock, and the molten laminate was discharged into a sheet shape from a T-shaped slit die set at 260°C. Thereafter, the discharged molten sheet was cooled for solidification in close contact on a casting drum held at 25°C with an air knife to obtain an unstretched film. At this time, the composition a was brought into contact with the casting drum.

Next, the unstretched polypropylene film was preheated to 133°C in a stepwise manner with a plurality of roll groups, passed between rolls heated to 123°C with a difference in circumferential speed as it was, and stretched 5.0 times in the longitudinal direction. Subsequently, the stretched film was cooled by passing the film between rolls maintained at 70°C, and then cooled to room temperature to obtain a uniaxially oriented film.

Furthermore, the obtained uniaxially oriented film was guided to a tenter, preheated to 166°C with the opposite ends in the film width direction being grasped with clips, stretched 9.8 times in the width direction at 161°C, and then heat-treated at 158°C while being relaxed by 12% in the width direction. Thereafter, with the opposite ends in the width direction remaining tensely gripped with the clips, the film was guided to the outside of the tenter through a cooling step at 140°C, and the clips at the opposite ends in the film width direction were released. Next, the film surface (on the A layer side serving as the surface in contact with the casting drum) was subjected to a corona discharge treatment at a treatment intensity of 25 W·min/m² under a mixed gas atmosphere (oxygen concentration: 0.8% by volume) in which a carbon dioxide gas and a nitrogen gas were mixed at a volume ratio of 15 : 85, and the obtained biaxially oriented polypropylene film was then wound up as a roll.

Subsequently, the biaxially oriented polypropylene film was unwound from a roll, and AlOx was vapor-deposited on the surface subjected to the corona discharge treatment to obtain a laminate having an AlOx vapor-deposited layer (D layer).

### (Production of regenerated pellets and production of laminate using regenerated pellets)

Then, the laminate was pulverized and compressed with a crusher, charged into an extruder controlled to have a hopper oxygen concentration of 0.05% and set at a temperature of 240°C, and kneaded and extruded, and the strand was cooled with water and then made into chips to obtain regenerated pellets (BR1). As a polypropylene-based resin raw material for the A layer, a mixture of A1 and AM1 at a mass ratio of 60 : 40 was used. In addition, as a raw material for the B layer, a mixture of B1, BM1, and BR1 at a mass ratio of 55 : 25 : 20 was used. Furthermore, as a raw material for the C layer, a mixture of C1 and CM1 at a mass ratio of 60 : 40 was used. The raw material of each layer was melt-extruded, biaxially stretched, heat-treated, and relaxed in the same manner and under the same conditions as in the "Production of laminate" section described above, and then subjected to a surface treatment and vapor deposition of the D layer on the film to obtain a laminate. The properties of the obtained laminate are shown in Table 1.

### (Example 2)

A laminate, regenerated pellets, and a laminate using the regenerated pellets were produced in the same manner as in Example 1 except that Al was vapor-deposited instead of AlOx to form a laminate having an Al layer (D layer). The characteristics of the obtained polypropylene film and the laminate are shown in Table 1.

### (Example 3)

A laminate, regenerated pellets, and a laminate using the regenerated pellets were produced in the same manner as in Example 1 except that BM1 was not used as the resin of the B layer and the composition and film formation conditions of each layer were as shown in Table 1. The characteristics of the obtained polypropylene film and the laminate are shown in Table 1.

### (Example 4)

A laminate, regenerated pellets, and a laminate using the regenerated pellets were produced in the same manner as in Example 3 except that Al was vapor-deposited instead of AlOx to form a laminate having an Al layer (D layer). The characteristics of the obtained polypropylene film and the laminate are shown in Table 1.

### (Example 5)

A laminate, regenerated pellets, and a laminate using the regenerated pellets were produced in the same manner as in Example 1 except that the film formation conditions were changed to those shown in Table 1. The characteristics of the obtained polypropylene film and the laminate are shown in Table 1.

### (Example 6)

A laminate, regenerated pellets, and a laminate using the regenerated pellets were produced in the same manner as in Example 1 except that the film formation conditions were changed to those shown in Table 1 and the relaxation ratio in the width direction was changed to 8%. The characteristics of the obtained polypropylene film and the laminate are shown in Table 1.

### (Example 7)

A laminate, regenerated pellets, and a laminate using the regenerated pellets were produced in the same manner as in Example 1 except that the film formation conditions were changed to those shown in Table 1, a mixture of A1 and P2 at a mass ratio of 99 : 1 was used as the polypropylene-based resin raw material for the A layer, and a mixture of C1 and P2 at a mass ratio of 99 : 1 was used as the raw material for the C layer. The characteristics of the obtained polypropylene film and the laminate are shown in Table 1.

### (Example 8)

A laminate, regenerated pellets, and a laminate using the regenerated pellets were produced in the same manner as in Example 1 except that the film formation conditions were changed to those shown in Table 1 and only A1 was used as the polypropylene-based resin raw material for the A layer. The characteristics of the obtained polypropylene film and the laminate are shown in Table 1.

### (Comparative Example 1)

As the polypropylene-based resin raw material for the A layer, a mixture of A1 and P1 at a mass ratio of 99 : 1 was used. In addition, as the raw material for the B layer, a mixture of B1 and BM1 at a mass ratio of 75 : 25 was used. Further, a biaxially oriented polypropylene film was produced in the same manner as in Example 1 except that a mixture of C1 and P1 at a mass ratio of 99 : 1 was used as the raw material for the C layer, and the film formation conditions were changed to the conditions shown in Table 1, and a laminate with the D layer deposited thereon was obtained. Production of regenerated pellets and production of a laminate using the regenerated pellets were not performed. The characteristics of the obtained polypropylene film and the laminate are shown in Table 1.

### (Comparative Example 2)

A laminate, regenerated pellets, and a laminate using the regenerated pellets were produced in the same manner as in Example 4 except that the vapor deposition thickness of Al constituting a laminate 1 was changed to 400 nm and the film formation conditions were changed to those shown in Table 1. The characteristics of the obtained polypropylene film and the laminate are shown in Table 1.

**[Table 1-1]**

| | | | Example 1 | Example 2 | Example 3 | Example 9 | Example 5 |
|---|---|---|---|---|---|---|---|
| Layer configuration of polypropylene film (common to laminates 1 and 2) | Configuration | - | A/B/C | A/B/C | A/B/C | A/B/C | A/B/C |
| | Lamination ratio | - | 1/10/1 | 1/10/1 | 1/12/1 | 1/10/1 | 1/10/1 |
| Raw material of laminate 1 | Raw material for A layer | Mass ratio | A1/AM1 = 60/40 | A1/AM1 = 60/40 | A1/AM1 = 60/40 | A1/AM1 = 60/40 | A1/AM1 = 60/40 |
| | Raw material for B layer | Mass ratio | B1/BM1 = 75/25 | B1/BM1 = 75/25 | B1 = 100 | B1 = 100 | B1/BM1 = 75/25 |
| | Raw material for C layer | Mass ratio | C1/CM1 = 60/40 | C1/CM1 = 60/40 | C1/CM1 = 60/40 | C1/CM1 = 60/40 | C1/CM1 = 60/40 |
| | Type of D layer | | AlOx | Al | AlOx | Al | AlOx |
| Raw material of laminate 2 | Raw material for A layer | Mass ratio | A1/AM1 = 60/40 | A1/AM1 = 60/40 | A1/AM1 = 60/40 | A1/AM1 = 60/40 | A1/AM1 = 60/40 |
| | Raw material for B layer | Mass ratio | B1/BM1/BR1 = 55/25/20 | B1/BM1/BR1 = 55/25/20 | B1/BR1 = 80/20 | B1/BM1/BR1 = 55/25/20 | B1/BM1/BR1 = 55/25/20 |
| | Raw material for C layer | Mass ratio | C1/CM1 = 60/40 | C1/CM1 = 60/40 | C1/CM1 = 60/40 | C1/CM1 = 60/40 | C1/CM1 = 60/40 |
| | Type of D layer | - | AlOx | Al | AlOx | Al | AlOx |
| Film formation conditions (common to laminates 1 and 2) | Preheating temperature of longitudinal stretching | (°C) | 133 | 133 | 144 | 144 | 148 |
| | Longitudinal stretching temperature | (°C) | 123 | 123 | 140 | 141 | 146 |
| | Preheating temperature of lateral stretching | (°C) | 166 | 166 | 167 | 166 | 171 |
| | Lateral stretching temperature | (°C) | 161 | 161 | 166 | 161 | 168 |
| | Heat treatment temperature | (°C) | 158 | 158 | 150 | 151 | 155 |
| Characteristics of biaxially oriented polypropylene film used for laminate 2 | Thickness of film | (µm) | 12 | 12 | 14 | 12 | 12 |
| | Temperature XlTs | (°C) | 133 | 131 | 112 | 110 | 119 |
| | Type of particles | (-) | AlOx | Al | AlOx | Al | AlOx |
| | Aspect ratio of particles in plane parallel to Y1 direction and perpendicular to thickness direction | (-) | 135 | 31 | 123 | 33 | 131 |
| | Aspect ratio of particles in plane parallel to X1 direction and perpendicular to thickness direction | (-) | 70 | 14 | 65 | 18 | 68 |
| | Length of short side of particles | (nm) | 5 | 65 | 5 | 69 | 5 |
| | Total light transmittance | (%) | 92 | 85 | 91 | 84 | 89 |
| | b value* | (-) | 0.12 | 0.16 | 0.12 | 0.15 | 0.12 |
| | Peak melting temperature (Tm) | (°C) | 173 | 173 | 171 | 173 | 173 |
| | Average roughness (Sa) of surface of A layer | (nm) | 20 | 21 | 25 | 29 | 36 |
| | Root mean square height (Sq) of surface of A layer | (nm) | 26 | 30 | 31 | 47 | 55 |
| | Average roughness (Sa) of opposite surface | (nm) | 35 | 39 | 41 | 41 | 49 |
| | Root mean square height (Sq) of opposite surface | (nm) | 40 | 51 | 48 | 58 | 67 |
| Characteristics of laminate 2 | Thickness of D layer | (nm) | 7 | 80 | 7 | 80 | 7 |
| | X2Ts | (°C) | 131 | 125 | 111 | 109 | 118 |
| | Total light transmittance | (%) | 92 | 35 | 91 | 34 | 89 |
| | Water vapor barrier properties | - | S | S | B | B | A |
| | Oxygen barrier properties | - | S | A | B | B | B |

**[Table 1-2]**

| | | | Example 6 | Example 7 | Example 8 | Comparative Example 1 | Comparative Example 2 |
|---|---|---|---|---|---|---|---|
| Layer configuration of polypropylene film (common to laminates 1 and 2) | Configuration | - | A/B/C | A/B/C | A/B/C | A/B/C | A/B/C |
| | Lamination ratio | - | 1/10/1 | 1/10/1 | 1/10/1 | 1/10/1 | 1/10/1 |
| Raw material of laminate 1 | Raw material for A layer | Mass ratio | A1/AM1 = 60/40 | A1/P2 = 99/1 | A1 = 100 | A1/P1 = 99/1 | A1/AM1 = 60/40 |
| | Raw material for B layer | Mass ratio | B1/BM1 = 75/25 | B1/BM1 = 75/25 | B1/BM1 = 75/25 | B1/BM1 = 75/25 | B1 = 100 |
| | Raw material for C layer | Mass ratio | C1/CM1 = 60/40 | C1/P2 = 99/1 | C1/CM1 = 60/40 | C1/P1 = 99/1 | C1/CM1 = 60/40 |
| | Type of D layer | | AlOx | AlOx | AlOx | AlOx | Al |
| Raw material of laminate 2 | Raw material for A layer | Mass ratio | A1/AM1 = 60/40 | A1/P2 = 99/1 | A1 = 100 | - | A1/AM1 = 60/40 |
| | Raw material for B layer | Mass ratio | B1/BM1/BR1 = 55/25/20 | B1/BM1/BR1 = 55/25/20 | B1/BM1/BR1 = 55/25/20 | - | B1/BR1 = 80/20 |
| | Raw material for C layer | Mass ratio | C1/CM1 = 60/40 | C1/P2 = 99/1 | C1/CM1 = 60/40 | - | C1/CM1 = 60/40 |
| | Type of D layer | - | AlOx | AlOx | AlOx | - | Al |
| Film formation conditions (common to laminates 1 and 2) | Preheating temperature of longitudinal stretching | (°C) | 132 | 145 | 134 | 134 | 146 |
| | Longitudinal stretching temperature | (°C) | 122 | 147 | 123 | 124 | 146 |
| | Preheating temperature of lateral stretching | (°C) | 166 | 171 | 166 | 165 | 167 |
| | Lateral stretching temperature | (°C) | 162 | 168 | 162 | 160 | 167 |
| | Heat treatment temperature | (°C) | 157 | 156 | 158 | 157 | 145 |
| Characteristics of biaxially oriented polypropylene film used for laminate 2 | Thickness of film | (µm) | 12 | 12 | 12 | 12 | 14 |
| | Temperature XlTs | (°C) | 117 | 118 | 132 | 113 | 91 |
| | Type of particles | (-) | AlOx | AlOx | AlOx | PMMA | Al |
| | Aspect ratio of particles in plane parallel to Y1 direction and perpendicular to thickness direction | (-) | 133 | 131 | 133 | 1. 9 | 1.9 |
| | Aspect ratio of particles in plane parallel to X1 direction and perpendicular to thickness direction | (-) | 68 | 65 | 72 | 1.2 | 1.8 |
| | Length of short side of particles | (nm) | 5 | 5 | 5 | 250 | 290 |
| | Total light transmittance | (%) | 92 | 91 | 92 | 69 | 72 |
| | b value* | (-) | 0.12 | 0.12 | 0.12 | 0.16 | 0.16 |
| | Peak melting temperature (Tm) | (°C) | 171 | 171 | 173 | 172 | 165 |
| | Average roughness (Sa) of surface of A layer | (nm) | 26 | 32 | 14 | 45 | 49 |
| | Root mean square height (Sq) of surface of A layer | (nm) | 32 | 65 | 21 | 215 | 131 |
| | Average roughness (Sa) of opposite surface | (nm) | 38 | 36 | 36 | 63 | 72 |
| | Root mean square height (Sq) of opposite surface | (nm) | 49 | 75 | 41 | 220 | 154 |
| Characteristics of laminate 2 | Thickness of D layer | (nm) | 7 | 7 | 7 | 7 | 80 |
| | X2Ts | (°C) | 116 | 117 | 131 | 113 | 88 |
| | Total light transmittance | (%) | 92 | 91 | 92 | 81 | 33 |
| | Water vapor barrier properties | - | A | B | s | C | C |
| | Oxygen barrier properties | - | A | B | s | C | C |

In the table, a laminate produced first is referred to as the laminate 1, and a laminate using regenerated pellets is referred to as a laminate 2. Since the laminate of Comparative Example 1 contains P1 having a large particle size as the particles, it is apparent that coarse protrusions are formed and the barrier properties are inferior even when the laminate is produced using the regenerated pellets formed of the laminate as the B layer. Therefore, in Comparative Example 1, a laminate using the regenerated pellets was not produced, and the laminate produced first was evaluated. Further, in Examples 1 to 7 and Comparative Example 2, the regenerated pellets of the laminate 1 produced in these examples and comparative examples were used for the production of the laminate 2 (that is, all the regenerated pellets are denoted as BR1 in the table, but since the laminates 1 as the raw materials in the examples and comparative examples are different from one another, the materials are not the same even if the denotations are the same).

### INDUSTRIAL APPLICABILITY

The present invention can provide a polypropylene film having excellent thermal dimensional stability, and high oxygen barrier properties and water vapor barrier properties even while using a recycled deposited film, and for example, the polypropylene film is suitably used for packaging materials.

## Claims

1. A polypropylene film comprising a particle, wherein a temperature XlTs is 100°C or more and 160°C or less where a direction in which a shrinkage ratio is largest at 140°C in a temperature increase process of thermomechanical analysis (TMA) is defined as an X1 direction, and a temperature at which a 1% shrinkage occurs in the X1 direction is defined as the temperature X1Ts, and the particle is at least one of a metal particle and an inorganic compound particle.

2. A polypropylene film comprising a particle, wherein an aspect ratio of the particle observed in a cross section cut along a plane parallel to a Y1 direction and perpendicular to a thickness direction is 2 or more where a direction orthogonal in a film plane to a direction in which a shrinkage ratio is largest at 140°C in a temperature increase process of thermomechanical analysis (TMA) is defined as the Y1 direction, and the particle is at least one of a metal particle and an inorganic compound particle.

3. The polypropylene film according to claim 1, wherein an aspect ratio of the particle observed in a cross section cut along a plane parallel to the X1 direction and perpendicular to the thickness direction is 2 or more.

4. The polypropylene film according to any one of claims 1 to 3, wherein a length of a short side of the particle observed in a cross section cut along a plane parallel to the X1 direction and perpendicular to the thickness direction is less than 100 nm and nm or less.

5. The polypropylene film according to any one of claims 1 to 4, wherein the inorganic compound particle is an inorganic oxide particle and contains at least one of alumina, silica, and an oxide of aluminum and silicon.

6. The polypropylene film according to any one of claims 1 to 5, wherein an average roughness (Sa) of at least one surface measured by three-dimensional non-contact surface profile measurement is 30 nm or less, and a root mean square height (Sq) is 50 nm or less.

7. The polypropylene film according to any one of claims 1 to 6, wherein a total light transmittance is more than 70% and less than 100%.

8. The polypropylene film according to any one of claims 1 to 7, wherein a peak melting temperature (Tm) of the film obtained by heating the film from 30°C to 260°C at 20°C/min with a differential scanning calorimeter DSC is 160°C or more.

9. The polypropylene film according to any one of claims 1 to 8, wherein a b value* measured with a spectral color difference meter is -2.00 or more and 2.00 or less.

10. A laminate comprising: the polypropylene film according to any one of claims 1 to 9; and a layer (D layer) containing a metal and an inorganic compound in a total amount of more than 50% by mass and 100% by mass or less on at least one surface of the polypropylene film.

11. The laminate according to claim 10, wherein a total light transmittance is more than 70% and less than 100%.

12. The laminate according to claim 10 or 11, wherein a temperature X2Ts is 100°C or more and 160°C or less where a direction in which a shrinkage ratio is largest at 140°C in a temperature increase process of thermomechanical analysis (TMA) is defined as a X2 direction, and a temperature at which a 0.1% shrinkage occurs in the X2 direction is defined as the temperature X2Ts.

13. The laminate according to any one of claims 10 to 12, wherein the laminate is used for a packaging material.

14. A packaging material comprising the laminate according to any one of claims 10 to 13.

15. A packaged body comprising a content packed using the packaging material according to claim 14.

16. A method for manufacturing the polypropylene film according to any one of claims 1 to 9, comprising, in this order:
a melting step of melting a laminate including a polypropylene layer and a layer (D layer) containing a metal and an inorganic compound in a total amount of more than 50% by mass and 100% by mass or less;
a casting step of melting a mixed resin containing 1% by mass or more and 99% by mass or less of a melt obtained in the melting step and ejecting the melted resin into a sheet from a die, and cooling and solidifying the melted resin on a support to obtain a polypropylene sheet;
a stretching step of stretching the polypropylene sheet in two orthogonal directions; and
a heat treatment step of subjecting the film obtained in the stretching step to a heat treatment and a relaxation treatment.

17. The method for manufacturing a polypropylene film according to claim 16, wherein at least one surface of the polypropylene film is subjected to a surface treatment in a mixed atmosphere gas of nitrogen and a carbon dioxide gas.
